# EUROPÄISCHE PATENTSCHRIFT

(11) **EP 2 305 602 B1**
(45) Veröffentlichungstag und Bekanntmachung des Hinweises auf die Patenterteilung: **09.05.2012**
(21) Anmeldenummer: 10174864.8
(22) Anmeldetag: 01.09.2010
(51) Int. Cl.: C01B 33/035

(54) **Verfahren zur Herstellung von stabförmigem Polysilicium mit verbesserter Brucheigenschaft**
Process for preparing rod-type polysilicon having improved breaking properties
Procédé de preparation de poly-silicium en forme de tige doté d'une propriété de rupture améliorée

(30) Priorität: 24.09.2009 DE 102009044991
(43) Veröffentlichungstag der Anmeldung: 06.04.2011
(73) Patentinhaber: Wacker Chemie AG, 81737 München (DE)
(72) Erfinder: Sofin, Mikhail, 84489, Burghausen (DE)
(74) Vertreter: Budczinski, Angelika

(56) Entgegenhaltungen:
- EP-A1- 1 391 252
- EP-A2- 0 329 163
- DE-A1- 4 223 458
- DE-A1-102007 047 210
- JP-A- 2005 288 332
- JP-A- 2006 089 353
- JP-A- 2010 180 078

## Beschreibung

Die Erfindung betrifft die Herstellung von stabförmigem Polysilicium mit verbesserten Brucheigenschaften, erhalten nach dem Siemens Abscheide-Verfahren.

Polykristallines Silicium (Polysilicium) dient als Ausgangsmaterial zur Herstellung von einkristallinem Silicium für Halbleiter nach dem Czochralski oder Zonenschmelz Verfahren, sowie zur Herstellung von ein- oder multikristallinem Silicium nach verschiedenen Zich- und Gieß-Verfahren zur Produktion von Solarzellen für die Photovoltaik.

Das Polysilicium wird dabei hauptsächlich durch Abscheidung mit Trichlorsilan nach dem sogenannten Siemens-Verfahren hergestellt. Bei diesem Verfahren werden in einem glockenförmigen Reaktor, dem sogenannten "Siemens-Reaktor", dünne Filamentstäbe aus Silicium durch direkten Stromdurchgang erhitzt und mit einem Reaktionsgas aus Wasserstoff und einer oder mehrerer siliciumhaltigen Komponenten in Kontakt gebracht. Bevorzugter Rohstoff ist dabei Trichlorsilan (SiHCl3) oder dessen Mischung mit Dichlorsilan (SiH2Cl2). Entsprechende Verfahren zur Herstellung von stabförmigem polykristallinen Silicium sind z.B. aus DE 10 2007 047210 A1, JP 2005 288332 A, JP 2006 089353 A, EP 1 391 252 A1 und DE 42 23 458 A1 bekannt.

Die Filamentstäbe stecken senkrecht in am Reaktorboden befindlichen Elektroden über die der Anschluss an die Stromversorgung erfolgt. An den erhitzten Filamentstäben und der waagrechten Brücke, die jeweils zwei Stäbe verbindet, scheidet sich hochreines Polysilicium ab, wodurch der Stabdurchmesser mit der Zeit anwächst.

Nachdem der gewünschte Durchmesser erreicht ist, wird die weitere Zufuhr von Si-haltigen Komponenten beendet. Anschließend wird der Reaktor gespült, um alle gasförmigen Reaktionsprodukten und die Reste der Si-haltigen Komponenten zu entfernen. Die Spülung erfolgt in der Regel entweder mit Wasserstoff oder mit einem Inertgas, wie beispielsweise Stickstoff oder Argon. Nach der Spülung wird der Zufluss des Spülgases beendet und die Energiezufuhr wird abrupt oder mit einer bestimmten Rampe auf Null reduziert, so dass sich die entstandenen Si-Stäbe auf die Umgebungstemperatur abkühlen.

Nachdem die Stäbe abgekühlt sind und (falls die Spülung nicht mit Inertgas erfolgte) Wasserstoff in der Reaktorglocke gegen ein Inertgas ausgetauscht wurde, wird der Abscheidereaktor geöffnet und die Trägekörper mit den Polysiliciumstäben werden aus dem Reaktor entnommen.

Für verschiedene Verwendungen der Polysiliciumstäbe ist es nun notwendig, die Stäbe in einem nachfolgenden Schritt in kleine Stücke zu brechen. Si-Stäbe, die nach dem herkömmlichen Siemens-Verfahren hergestellt werden, sind sehr hart und benötigen zum Zerbrechen daher hohe Kräfte. Dies führt dazu, dass während des entsprechenden Brechverfahrens Si-Bruchstücke an der Oberfläche signifikant mit Material von Brechwerkzeugen kontaminiert sind. Außerdem sollen nach dem Brechen möglichst viele Si-Bruchstücke im vorgewählten Größenbereich liegen. Beim Brechen von Si-Stäben nach dem Stand der Technik entstehen viele Bruchstücke, die nicht der erwünschten Größe entsprechen und folglich zu wesentlich herabgesetzten Preisen verkauft werden müssen.

EP 0329163 beschreibt ein Verfahren zum Verbessern der Brecheigenschaften von Polysilicium, bei dem die Si-Stäbe nach der Abscheidung in einer Nachbehandlung nochmals aufgewärmt und abgeschreckt oder einer Druckwelle unterworfen werden. Dieses Verfahren ist allerdings mit sehr großem technischem Aufwand, hohen Kosten und Kontaminationsgefahr verbunden.

Bei der Herstellung dicker polykristalliner Si-Stäbe ist relativ häufig zu beobachten, dass sie während der Abkühlphase im Reaktor nach der Abscheidung aus den Halterungen kippen und umfallen. Dieses Phänomen verzögert den Herstellprozess erheblich, da die umgekippten Stäbe nur mit zusätzlichem Aufwand aus dem Reaktor entnommen werden können.

Weiterhin entsteht dadurch auch hoher finanzieller Schaden, da gekippte oder sogar zusammengebrochene Si-Stäbe nicht mehr wie vorgesehen weiterverarbeitet werden können. Besonders hoch ist der Schaden bei der Herstellung von Polysilicium für die Solar-Industrie, weil dieses Material normalerweise ohne zusätzliche Reinigungsschritte eingesetzt wird. Umgefallene Stäbe müssen anschließend einer aufwendigen Reinigung unterzogen werden, die das Solar-Material deutlich verteuert.

Aus US 5,593,465 ist bekannt, mindestens ein Federelement zwischen der Stromzuführung und der Elektrodenfassung anzuordnen, welches eine Bewegung der Elektrodenfassung relativ zur Stromdurchführung gestattet und diese Bewegung abfedert. Durch diese Anordnung soll ein Umfallen der Si-Stäbe minimiert werden. Nachteilig an dieser Lösung sind aber der große technische Aufwand und die damit verbundenen erheblichen Kosten.

US 6,639,192 empfiehlt den Einsatz von Kohleelektroden mit hoher Wärmeleitfähigkeit, um ein Umfallen der Stäbe im Reaktor zu verhindern. Dieser Lösungsansatz hat allerdings den gravierenden Nachteil, dass wegen der hohen Wärmeleitfähigkeit von Kohleelektroden, diese während des Abscheideprozesses nicht oder nur wenig von Silicium überwachsen werden. Dies führt dazu, dass die Stäbe schon zu Beginn der Abscheidung leicht umkippen können.

Das Ziel der vorliegenden Erfindung ist es, ein Verfahren zur Herstellung von polykristallinen Silicium-Stäben mit großem Durchmesser (>100 mm) aus hochreinem Silicium für Anwendungen in der Halbleiter-Industrie sowie in der Solar-Industrie, für verschiedene Zieh- und Gieß-Verfahren zur Produktion von Solarzellen für die Photovoltaik, bereitzustellen, die ein verbessertes Bruchverhalten aufweisen um die damit verbundene Kontamination der Si-Bruchstücke signifikant zu reduzieren und den Anteil von Silicium Bruchstücken mit unerwünschten Größen zu verringern.

Ein weiteres Ziel der Erfindung ist die Reduzierung der Herstellungskosten der polykristallinen Silicium-stäbe durch eine Vermeidung des Umkippens der Stäbe während der Abkühlphase.

Überraschenderweise wurde gefunden, dass polykristalline Siliciumstäbe, durch einen speziellen Ausfahrprozess unter Zusatz von Wasserstoff am Ende der Abscheidung nach dem Siemens-Verfahren, definierte Risse und Spannungen erhalten und damit in der späteren Weiterverarbeitung leichter zu Stücken gebrochen werden können. Ein weiter überraschender Vorteil der erfindungsgemäßen Nachbehandlung ist die Verringerung der Quote an Stäben, die im Reaktor umfallen.

Gegenstand der Erfindung ist ein Verfahren zur Herstellung von stabförmigen, polykristallinen Silicium mit einem Stabdurchmesser von >100 mm durch Abscheidung mit siliciumhaltigem Gas nach dem Siemens-Verfahren, dadurch gekennzeichnet, dass die Si-Stäbe am Ende des Abscheideprozesses während des Abkühlens im Reaktor mit Wasserstoff in Kontakt gebracht werden, wobei der Wasserstoffdurchfluss und/oder der Wasserstoffdruck so gewählt sein muss, dass die bei diesen Durchfluss und/oder Druck für die Aufrechterhaltung der Abscheidetemperatur benötige Leistung mindestens 50 % von der Leistung am Abscheideende beträgt, aber nicht weniger als 5 kW pro 1 m Stablänge, und die abgekühlten Si-Stäbe im senkrechten Querschnitt Risse und/oder radiale Spannungen mit einer Größe von mindestens 1·10⁻⁴ cm⁻¹ aufweisen.

Das erfindungsgemäß hergestellte stabförmige, polykristalline Silicium mit einem Stabdurchmesser von >100 mm entsteht dadurch, dass während des Abkühlens der Si-Stäbe eine hohe Wasserstoffmenge in den Reaktor eingeleitet wird und/oder der Druck im Reaktor angehoben wird. Bevorzugt wird dabei der Wasserstoff während der Phase der Reduzierung der Temperatur von der AbscheideTemperatur auf die Umgebungstemperatur. Die Beaufschlagung mit Wasserstoff kann auch bereits bei höheren Temperaturen als die Umgebungstemperatur beendet werden, jedoch muss diese mindestens bis zu einer Stabtemperatur 800 °C eingehalten werden.

Der Wasserstoffdurchfluss und/oder der Druck müssen so ausgewählt werden, dass die bei diesen Durchfluss und Druck für die Aufrechterhaltung der Abscheidetemperatur benötige Leistung mindesten 50 % von der Leistung am Abscheideende beträgt, aber nicht weniger als 5 kW pro 1 m Stablänge.

Bevorzugt wird hierbei ein Druck im Reaktor zwischen 2 und 30 bar, besonders bevorzugt zwischen 3 und 20 bar. Der Wasserstoffdurchfluss beträgt bevorzugt zwischen 2 und 100 Nm3/h pro 1 m Stablänge, besonders bevorzugt zwischen 5 und 50 Nm3/h pro Stablänge.

Diese Fahrweise führt dazu, dass Si-Stäbe während des Abkühlens sehr verspannt werden und viele Risse bekommen. Dadurch können die Si-Stäbe in der weiteren Verarbeitung sehr leicht gebrochen werden, so dass die Si-Bruchstücke nur sehr wenig durch den Abrieb von den eingesetzten Brechwerkzeugen kontaminiert werden. Ein weiterer Vorteil ist, dass der Anteil der minderwertigen kleinen Silicium-Bruchstücke verringert wird.

Betrachtet man die Querschnitte der erfindungsgemäß hergestellten Si-Stäbe in senkrechter Richtung zum Dünnstab, so weisen mindestens 80% der Querschnitte Risse und/oder radiale Spannungen größer 1·10⁻⁴ cm⁻¹ auf. Diese Risse in den polykristallinen Si-Stäben können visuell oder mittels bekannter Verfahren, wie beispielsweise Klangprüfung, Farbeindringprüfung oder Ultraschalltechnik detektiert werden. Ein Verfahren zur Messung von mechanischen Spannungen in polykristallinen Stäben ist beispielhaft in US 5,976,481 beschrieben.

Beim Brechen von kompakten polykristallinen Si-Stäben werden für die meisten Anwendungen Bruchstücke mit einer Größe im Bereich von 50 bis 100 mm bevorzugt. Bei herkömmlichen Si-Stäben wird mittels der bekannten Bruchverfahren ein maximaler Gewichtsanteil von 65 %, bezogen auf die Gesamtmenge, an Bruchstücken der Zielgröße erzielt. Der Anteil an Bruchstücken mit einer Größe unter 10 mm beträgt dabei 2,5 bis 5 %.

Im Gegensatz dazu werden beim Brechen des erfindungsgemäßen stabförmigen- polykristallinen Siliciumstäben Bruchstücke mit einer Größe im Bereich von 50 bis 100 mm deutlich auf über 70 %, bezogen auf die Gesamtmenge, erhöht. Der Anteil an kleinen Bruchstücken unter 10 mm kann dabei auf unter 2 % reduziert werden. Bei den heute üblichen industriellen Herstellmengen von mehreren 10.000 Tonnen pro Jahr bedeutet dies eine enorme Kostenersparnis.

In der Regel werden bei den aus dem Stand der Technik bekannten Brechverfahren Werkzeuge aus Wolframcarbid eingesetzt. Dabei wird die Oberfläche des gebrochenen Zielmaterials mit 1 bis 2 ppbw Wolfram kontaminiert. Beim Einsatz des erfindungsgemäßen Materials besitzen dagegen die wichtigen 50 bis 100 mm großen Bruchstücke eine Kontamination von weniger als 0,8 ppbw. Bei Verwendung von Brechwerkzeugen aus anderen Materialien wird die Kontamination durch das Werkzeugmaterial ebenfalls deutlich verringert. So wurde herausgefunden, dass die durchschnittliche Kontamination durch den Einsatz des erfindungsgemäßen Materials um mindestens 20% reduziert wird.

Überraschenderweise wurde als weiterer Effekt der erfindungsgemäß hergestellten polykristallinen Si-Stäbe beobachtet, dass diese im Reaktor weniger zum Umkippen neigen. Die Quote der umgekippten Si-Stäbe konnte im Vergleich zum Stand der Technik um mehr als 50 % reduziert werden. Durch die erfindungsgemäßen Spannungen und Risse in den Si-Stäben, sind diese zwar mittels Brechwerkzeuge einfacher zu brechen, besitzen aber gleichzeitig im Reaktor stehenden Zustand eine höhere Belastbarkeit gegenüber dem Umkippen.

Anhand der folgenden Beispiele soll die Erfindung näher erläutert werden.

Die Beispiele wurden in einem Siemensreaktor mit 8 Stäben durchgeführt. Die eingesetzten Dünnstäbe waren aus Reinstsilicium mit einer Länge von 2 m und hatten einen Durchmesser von 5 mm. Für die Abscheidung wurde ein Gemisch aus Wasserstoff und Trichlorsilan eingesetzt. Die Temperatur der Stäbe betrug 1000 °C während der gesamten Abscheidungszeit. Der Druck im Reaktor betrug 3 bar. Die Abscheidung lief, bis die Stäbe den Durchmesser von 160 mm erreichten. Die am Ende der Abscheidung benötigte Leistung lag bei etwa 25 kW pro 1 m Stablänge.

### Vergleichsbeispiel:

Nach dem die Stäbe einen Durchmesser von 160 mm erreicht hatten wurde die Zufuhr von Trichlorsilan beendet. Anschließend wurde der Reaktor für 1 Stunde mit reinem Wasserstoff gespült. Dann wurde die Wasserstoff-Zufuhr beendet. Die benötigte Leistung betrug dabei 5 kW pro 1 m Stablänge. Danach wurde die Temperatur der Stäbe innerhalb von einer Stunde von 1000 °C auf 500 °C abgesenkt und anschließend wurde die Stromversorgung abgeschaltet. Nach Abkühlung der Stäbe und Ersetzen des Gases in der Reaktionsglocke durch Stickstoff wurde der Abscheidereaktor geöffnet und die Trägekörper wurden aus dem Reaktor entnommen. In einem nachfolgenden Schritt wurden die Stäbe mit Hämmern aus Wolframkarbid gezielt auf Stücke mit einer Größe von 50 bis 100 mm gebrochen. Insgesamt wurde mit diesem Verfahren 100 Chargen abgeschieden. 10 % der Stäbe sind während des Abkühlens umgefallen und waren ohne spätere Reinigung unbrauchbar. Bei jedem Stab wurden mehrere Querschnitte analysiert. Etwa 30 % der analysierten Querschnitte wiesen Risse und/oder Spannungen von größer 1·10⁻⁴ cm⁻¹ auf. Beim Brechen der Stäbe fielen etwa 3,5 % der Bruchstücke in einer Größe unter 10 mm an. Die bevorzugten Si-Bruchstücke der Zielgröße von 50 bis 100 mm sind durchschnittlich mit 61% angefallen und hatten im Mittel eine Wolfram-Kontamination von 3,4 ppbw.

### Beispiel 1:

Nach dem die Stäbe einen Durchmesser von 160 mm erreicht hatten wurde die Zufuhr von Trichlorsilan beendet. Anschließend wurde der Reaktor für 1 Stunde mit reinem Wasserstoff gespült. Dann wurde der Wasserstoff-Druck in der Anlage auf 10 bar und der Wasserstoff-Durchfluss auf 200 Nm3/h angehoben. Die benötigte Leistung betrug dabei 15 kW pro 1 m Stablänge. Danach wurde Temperatur der Stäbe innerhalb von einer Stunde von 1000 °C auf 500 °C abgesenkt und anschließend wurde die Stromversorgung abgeschaltet. Nach Abkühlung der Stäbe und Ersetzen des Gases in der Reaktionsglocke durch Stickstoff wurde der Abscheidereaktor geöffnet und die Trägekörper wurden aus dem Reaktor entnommen. In einem nachfolgenden Schritt wurden die Stäbe mit Hämmern aus Wolframkarbid gezielt auf Stücke mit einer Größe von 50 bis 100 mm gebrochen. Insgesamt wurde mit diesem erfindungsgemäßen Verfahren 200 Chargen abgeschieden. Im Gegensatz zum Stand der Technik sind nur 3 % der Stäbe sind während des Abkühlens umgefallen. Bei jedem Stab wurden mehrere Querschnitte analysiert. Etwa 92 % der analysierten Querschnitte wiesen Risse und/oder Spannungen größer 1·10⁻⁴ cm⁻¹ auf. Beim Brechen der Stäbe fielen etwa 1,5 % der Bruchstücke in einer Größe unter 10 mm an. Die bevorzugten Si-Bruchstücke der Zielgröße 50 bis 100 mm sind durchschnittlich mit 77% angefallen und hatten im Mittel eine Wolfram-Kontamination von 0,5 ppbw.

### Beispiel 2:

Nach dem die Stäbe einen Durchmesser von 160 mm erreicht hatten wurde die Zufuhr von Trichlorsilan beendet. Anschließend wurde der Reaktor für 1 Stunde mit reinem Wasserstoff gespült. Dann wurde der Wasserstoff-Durchfluss auf 200 Nm3/h angehoben. Der Druck in der Anlage wurde gleich dem Umgebungsdruck (etwa 1 bar) eingestellt. Die benötigte Leistung betrug dabei 13 kW pro 1 m Stablänge. Danach wurde Temperatur der Stäbe innerhalb von einer Stunde von 1000 °C auf 500 °C abgesenkt und anschließend wurde die Stromversorgung abgeschaltet. Nach Abkühlung der Stäbe und Ersetzen des Gases in der Reaktionsglocke durch Stickstoff wurde der Abscheidereaktor geöffnet und die Trägekörper wurden aus dem Reaktor entnommen. In einem nachfolgenden Schritt wurden die Stäbe mit Hämmern aus Wolframkarbid gezielt auf Stücke mit einer Größe von 50 bis 100 mm gebrochen. Insgesamt wurde mit diesem erfindungsgemäßen Verfahren 100 Chargen abgeschieden. Im Gegensatz zum Stand der Technik sind 5 % der Stäbe sind während des Abkühlens umgefallen. Bei jedem Stab wurden mehrere Querschnitte analysiert. Etwa 85 % der analysierten Querschnitte wiesen Risse und/oder Spannungen größer 1·10⁻⁴. cm⁻¹ auf. Beim Brechen der Stäbe fielen etwa 1,8 % der Bruchstücke in einer Größe unter 10 mm an. Die bevorzugten Si-Bruchstücke der Zielgröße 50 bis 100 mm sind durchschnittlich mit 73% angefallen und hatten im Mittel eine Wolfram-Kontamination von 0,7 ppbw.

## Patentansprüche

1. Verfahren zur Herstellung von stabförmigen, polykristallinen silicium um mit einem Stabdurchmesser von >100 mm, durch Abscheidung von siliciumhaltigem Gas nach dem Siemens-Verfahren, **dadurch gekennzeichnet, dass** die Si-Stäbe am Ende des Abscheideprozesses während des Abkühlens im Reaktor mit Wasserstoff in Kontakt gebracht werden, wobei der Wasserstoffdurchfluss und/oder der Wasserstoffdruck so gewählt sein muss, dass die bei diesen Durchfluss und/oder Druck für die Aufrechterhaltung der Abscheidetemperatur benötige Leistung mindestens 50 % von der Leistung am Abscheideende beträgt, aber nicht weniger als 5 kW pro 1 m Stablänge, und die abgekühlten Si-Stäbe im senkrechten Querschnitt Risse und/oder radiale Spannungen mit einer Größe von mindestens 1·10⁻⁴ cm⁻¹ aufweisen.

2. Verfahren nach Anspruch 1, **dadurch gekennzeichnet, dass** die Si-Stäbe während der Abkühlphase mindestens bis zu einer Stabtemperatur von 800 °C mit Wasserstoff in Kontakt gebracht werden.

3. Verfahren nach Anspruch 1 bis 2, **dadurch gekennzeichnet, dass** der Druck im Reaktor zwischen 2 und 30 bar beträgt.

4. Verfahren nach Anspruch 1 bis 3, **dadurch gekennzeichnet, dass** der Wasserstoffdurchfluss zwischen 2 und 100 Nm3/h pro 1 m Stablänge beträgt.

5. Verfahren nach Anspruch 1 bis 4, **dadurch gekennzeichnet, dass** 80% der Querschnitte in senkrechter Richtung zum Dünnstab gesehen, Risse und/oder radiale Spannungen größer 1·10⁻⁴ cm⁻¹ aufweisen.

## Claims

1. Method for producing rod-type, polycrystalline silicon having a rod diameter of >100 mm, by deposition of silicon-containing gas according to the Siemens method, **characterized in that** the Si rods are brought into contact with hydrogen at the end of the deposition process during cooling in the reactor, wherein the hydrogen flow rate and/or the hydrogen pressure must be chosen such that the power required in the case of said flow rate and/or pressure for maintaining the deposition temperature is at least 50% of the power at the end of deposition, but not less than 5 kW per 1 m rod length, and the cooled Si rods have in perpendicular cross section cracks and/or radial stresses having a size of at least 1·10⁻⁴ cm⁻¹.

2. Method according to Claim 1, **characterized in that** the Si rods are brought into contact with hydrogen during the cooling phase at least to a rod temperature of 800°C.

3. Method according to Claims 1 to 2, **characterized in that** the pressure in the reactor is between 2 and 30 bar.

4. Method according to Claims 1 to 3, **characterized in that** the hydrogen flow rate is between 2 and 100 Nm³/h per 1 m rod length.

5. Method according to Claims 1 to 4, **characterized in that** 80% of the cross sections as seen in a perpendicular direction with respect to the thin rod have cracks and/or radial stresses larger than 1·10⁻⁴ cm⁻¹.

## Revendications

1. Procédé de fabrication de silicium polycristallin en forme de bâton d'un diamètre de bâton > 100 mm, par dépôt d'un gaz contenant du silicium selon le procédé Siemens, **caractérisé en ce que** les bâtons de Si sont mis en contact avec de l'hydrogène à la fin du procédé de dépôt pendant le refroidissement dans le réacteur, le débit d'hydrogène et/ou la pression d'hydrogène devant être choisis de manière à ce que la puissance nécessaire pour maintenir la température de dépôt à ce débit et/ou à cette pression soit au moins 50 % de la puissance à la fin du dépôt, mais pas moins de 5 kW par m de longueur de bâton, et que les bâtons de Si refroidis présentent dans la section verticale des fissures et/ou des tensions radiales d'une taille d'au moins 1·10⁻⁴ cm⁻¹.

2. Procédé selon la revendication 1, **caractérisé en ce que** les bâtons de Si sont mis en contact avec de l'hydrogène pendant la phase de refroidissement au moins jusqu'à une température de bâton de 800 °C.

3. Procédé selon la revendication 1 ou 2, **caractérisé en ce que** la pression dans le réacteur est comprise entre 2 et 30 bar.

4. Procédé selon les revendications 1 à 3, **caractérisé en ce que** le débit d'hydrogène est compris entre 2 et 100 Nm³/h par m de longueur de bâton.

5. Procédé selon les revendications 1 à 4, **caractérisé en ce que** 80 % des sections dans la direction verticale vers le bâton mince présentent des fissures et/ou des tensions radiales supérieures à 1·10⁻⁴ cm⁻¹.
